Europäisches Patentamt

European Patent Office

Office européen des brevets

(19)

(11) Publication number: **0 136 486**
**A2**

(12) # EUROPEAN PATENT APPLICATION

(21) Application number: **84109497.2**

(22) Date of filing: **09.08.84**

(51) Int. Cl.⁴: **G 11 C 7/00**

(30) Priority: **06.09.83 US 529232**

(43) Date of publication of application:
**10.04.85 Bulletin 85/15**

(84) Designated Contracting States:
**DE FR GB IT NL**

(71) Applicant: **MOTOROLA, INC.**
**1303 East Algonquin Road**
**Schaumburg, Illinois 60196(US)**

(72) Inventor: **Novosel, David**
**15106 Springhill Lane**
**Pflugerville Texas 78660(US)**

(72) Inventor: **Barnes, John J.**
**16 Chapin Lane**
**Austin Texas 78746(US)**

(74) Representative: **Ibbotson, Harold et al,**
**Motorola Ltd Patent and Licensing Operations - Europe**
**Jays Close Viables Industrial Estate**
**Basingstoke Hampshire RG22 4PD(GB)**

(54) Latching output buffer.

(57) A latching output buffer (11) has an amplifier (50) for providing output signals on first and second nodes (23, 24) in response to complementary data signals (D,$\overline{D}$) when an equalization pulse (EQ) is not present. When the equalization pulse (EQ) is present, a latch (40) sustains the output signals on the first and second nodes (23, 24), and the amplifier (50) is not operational. When the equalization pulse (50) is not present, the latch (40) is not operational.

FIG. 1

EP 0 136 486 A2

# LATCHING OUTPUT BUFFER

This invention relates to output buffers, and more particularly, to latching output buffers for use in memory circuits.

## Background of the Invention

A technique for improving the speed-power product in memories is to use address transition detection to precharge and equalize bit lines. One or more address signals changing logic state constitutes an address transition. When an address transition is detected, an equalization pulse is generated. The equalization pulse typically is then used to precharge the bit lines. In the case-of-static random access memories (SRAMs) where there are a pair of complementary bit lines for each column, the equalization pulse is used to couple the complementary bit lines of each column together to equalize the voltage on them. Because equalizing bit lines in SRAMs was one of the first recognized uses of address transition detection, the pulse generated in response to an address transition is frequently known as an equalization pulse even if the equalization pulse has other uses, such as precharging.

One of the problems associated with equalizing bit lines is that the bit lines are certain to provide invalid data for the duration of the equalization pulse. With conventional sense amplifiers and output buffers the output data is also invalid upon equalization. Of course the address transition detection circuitry, sense amplifier, and output buffer are designed to be very fast. Consequently, the time from an address transition to invalid data may be very short. One solution has been to provide a high impedance output for the duration of the equalization pulse. Of course the output is still invalid but is simply high impedance when invalid. When operated at maximum cycle time, this has the result of providing valid data for a very short time. The output is not valid until some delay period caused by the sense amplifier and output buffer after termination of the equalization pulse. The output is then certain to be valid only until the next address transition.

## Summary of the Invention

An object of this invention is to provide an improved latching output buffer.

Another object of the invention is to provide an output buffer which extends the length of a valid output data signal.

Yet another object of the invention is to provide an output buffer which extends the time duration of output data for the duration of a predetermined signal.

These and other objects of this invention are achieved by an output buffer which has a data coupling circuit and a latch circuit. The data coupling circuit provides output signals on first and second nodes in response to complementary input signals when an enabling signal is present. The latch circuit latches the output signals on the first and second nodes when the enable signal is not present.

## Brief Description of the Drawings

FIG. 1 is a schematic diagram of an output buffer according to a preferred embodiment of the invention; and

FIG. 2 is a timing diagram of signals useful for describing the operation of the output buffer of FIG. 1.

## Description of a Preferred Embodiment

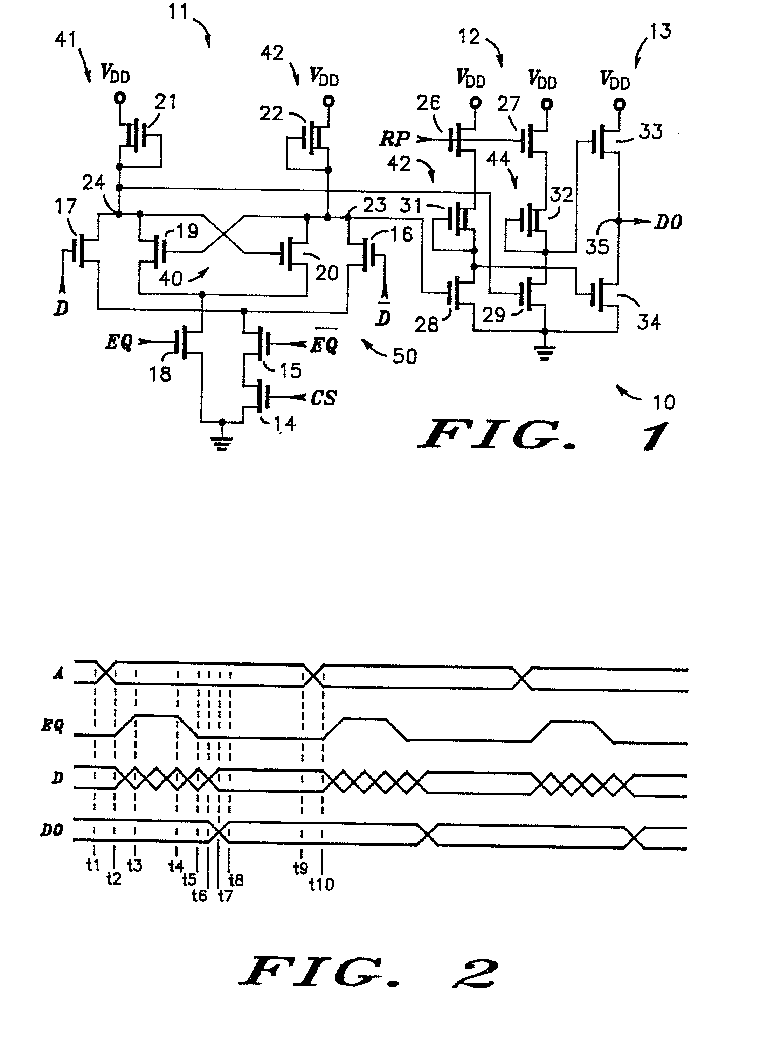

Shown in FIG. 1 is an output buffer 10 comprised generally of a signalized latch portion 11, an amplifier portion 12, and an output driver 13. Buffer 10 is comprised of N channel insulated gate field effect transistors of two types, enhancement and depletion. The depletion transistors, used as loads, have a threshold voltage between -2.5 and -3.5 volts. The enhancement transistors have a threshold voltage between 0.6 and 1.0 volt.

Signalized latch portion 11 comprises enhancement transistors 14, 15, 16, 17, 18, 19, and 20 and depletion transistors 21 and 22. Transistor 14 has a source connected to ground, a gate for receiving a chip select signal CS, and a drain. Transistor 15 has a source connected to the drain of transistor 14, a gate for receiving a complementary equalization pulse $\overline{EQ}$, and a drain. Transistor 16 has a source connected to the drain of transistor 15, a control electrode for receiving a complementary data signal $\overline{D}$, and a drain connected to a node 23. Transistor 17 has a source connected to the drain of transistor 15, a gate for receiving true data signal D, and a drain connected to a node 24. Transistor 18 has a source connected to ground, a control electrode for receiving an equalization pulse EQ, and a drain. Transistor 19 has a source connected to the drain of transistor 18, a gate connected to node 23, and a drain connected to node 24. Transistor 20 has a source connected to the drain of transistor 18, a gate connected to node 24, and a drain connected to node 23. Transistor 21 has a drain connected to a positive power supply terminal $V_{DD}$ which can be at, for example, 5 volts, and a gate and a source connected to node 24. Transistor 22 has a drain connected to $V_{DD}$, and a gate and a source connected to node 23.

Amplifier portion 12 comprises enhancement transistors 26, 27, 28, and 29, and depletion transistors 31 and 32. Transistor 26 has a drain connected to $V_{DD}$, a gate for receiving a read power-up signal RP, and a source. Transistor 27 has a drain connected to $V_{DD}$, a gate for receiving signal RP, and a source. Transistor 28 has a source connected to ground, a gate connected to node 23, and a drain. Transistor 29 has a source connected to ground, a gate connected to node 24, and a drain. Transistor 31 has a gate and a source connected to the drain of transistor 28, and a drain connected to the source of transistor 26. Transistor 32 has a gate and a source connected to the drain of transistor 29, and a drain connected to the source of transistor 27.

Output driver 13 comprises enhancement transistors 33 and 34. Transistor 33 has a drain connected to $V_{DD}$, a gate connected to the drain of transistor 29, and a source connected to a node 35. Transistor 34 has a source connected to ground, a gate connected to the drain of transistor 28, and a drain connected to node 35. Output driver 13 provides data out signal DO at node 35. Signals D and $\overline{D}$ are complementary signals which are provided by a sense amplifier (not shown) in response to bit line data (not shown).

Shown in FIG. 2 is a timing diagram of an address A which represents address signals (not shown). When the address signals are stable, address A is considered valid. When one or more of the address signals changes logic state, there is an address transition. At a time t1, an address transition begins. At a time t2 equalization pulse EQ begins being generated at which time signals D and $\overline{D}$ become invalid. Data out signal DO shown in FIG. 2 and as generated by buffer 10 of FIG. 2, remains valid after the occurrence of pulse EQ. With conventional output buffers, however, signal DO would become invalid in response to data signal D becoming invalid at time t2. One technique in the prior art was to cause the output which provided signal DO to become high impedance in response to pulse EQ. Signal DO shown in FIG. 2 does not become invalid until after pulse EQ terminates at time t5. With either a conventional buffer or buffer 10 of FIG. 1 new data will be valid very soon after data signal D becomes valid at time t7. At time t9 another address transition occurs with data signal D becoming invalid at time t10. With a conventional buffer signal DO would become invalid at time t10. Consequently signal DO would be valid only between times t8 and t10. The cycle time is from time t1 to time t9, i.e., the time between accesses to the memory which, for this case, is the time between address transitions. To shorten the cycle time, a typical goal, the time between times t8 and t10 can become very small, 3-4 nanoseconds. With a conventional buffer, consequently, the time of a valid DO signal can also be very short.

Buffer 10 of FIG. 1, while providing for an extended valid DO signal, does not add any additional propagation delay. A cross-coupled latch 40, comprised of transistors 18, 19, and 20, is added in parallel to a conventional buffer to form buffer 10. When an equalization pulse EQ is not present, buffer 10 operates in the same way as a conventional buffer. When providing signal DO in response to signal D and $\overline{D}$, signals CS and RP are a logic high. Consequently, transistors 14, 15, 26, and 27 are turned on. The sources of transistors 16 and 17 are thereby coupled to ground, and the drains of transistors 31 and 32 are thereby coupled to $V_{DD}$. Transistors 17 and 21 comprise an inverting amplifier 41, transistors 16 and 22 comprise an inverting amplifier 42, transistors 28 and 31 comprise an inverting amplifier 43, and transistors 29 and 32 comprise an inverting amplifier 44. Amplifiers 41 and 44 are interposed in series between signal D and transistor 33 of driver 13. With two inverting stages between signal D and transistor 33, the logic state of signal D will be present on the gate of transistor 33. Likewise for signal $\overline{D}$, with inverting amplifiers 42 and 43 interposed in series between signal $\overline{D}$ and transistor 34 of driver 13, the logic state of signal $\overline{D}$ will be present on the gate of transistor 34. If signal D is a logic high then the gate of transistor 33 will be a logic high, causing transistor 33 to be conducting. With signal D a logic high, signal $\overline{D}$ is a logic low so that the gate of transistor 34 is a logic low, turning transistor 34 off. With transistor 33 turned on and transistor 34 turned off, data out signal DO is provided as a logic high. Conversely, when signal D is a logic low and signal $\overline{D}$ is a logic high, transistor 33 is turned off and transistor 34 is turned on, causing signal DO to be provided as a logic low.

When pulse EQ is present, however, $\overline{EQ}$ is a logic low, turning off transistor 15 so that amplifiers 41 and 42 are no longer responsive to signals D and $\overline{D}$. With pulse EQ present, transistor 18 is turned on so that cross-coupled latch 40 becomes operational to latch the signals present at nodes 23 and 24. When EQ is not present, the logic states present at nodes 23 and 24 are determined by signals D and $\overline{D}$. When EQ becomes present, latch 40 maintains the logic states present at nodes 23 and 24. When EQ becomes present, signals D and $\overline{D}$ are invalid, but due to latch 40, the logic states at nodes 23 and 24 remain valid. Amplifiers 43 and 44 remain operational so that the logic states present on the gates of transistors 33 and 34 of output driver 13 remain valid. Consequently, data out signal DO remains valid. When EQ is no longer present, transistor 18 turns off and transistor 15 turns on as signals D and $\overline{D}$ become valid.

With transistor 15 turned on nodes 23 and 24 become responsive to signals D and $\overline{D}$. With transistor 18 off, latch 40 no longer is operational. Amplifiers 41 and 42 along with transistor 15 form a first amplifier stage 50 for signals D and $\overline{D}$ which provides data on nodes 23 and 24 in response to signals D and $\overline{D}$ when $\overline{EQ}$ is present. Latch 40 latches the data at nodes 23 and 24 when $\overline{EQ}$ is not present which corresponds to the time equalization pulse EQ is present.

Consequently, output buffer 10 continues to maintain signal DO in a valid condition for the duration of equalization pulse EQ instead of going to a high impedance as with a conventional buffer. This is achieved by latch 40 connected to nodes 23 and 24 in parallel with amplifier 50 so that no intervening elements are added between amplifier 50 and amplifier 12 to cause any additional propagation delay. Only four transistors, transistors 15, 18, 19, and 20, are added to a conventional buffer to achieve the result. Additionally, the two transistors required for the high impedance state of a conventional buffer are not now required.

## Claims

1. An output buffer comprising:
    data means for providing output signals on first and
        second nodes in response to complementary input
        signals when an enable signal is present; and
    latching means coupled to the first and second nodes
        for latching the output signals thereat when the
        enable signal is not present.

2. The output buffer of claim 1 further comprising:
    a first amplifier having an input directly connected
        to the first node, and an output; and
    a second amplifier having an input directly connected
        to the second node, and an output.

3. The output buffer of claim 2 further comprising an
output driver having a first input coupled to the output
of the first amplifier, a second input coupled to the
output of the second amplifier, and an output for
providing a data out signal.

4. The output buffer of claim 1 wherein the latching
means comprises:
    a first transistor having a first current electrode
        coupled to the first node, a control electrode
        coupled to the second node, and a second current
        electrode;
    a second transistor having a first current electrode
        coupled to the second node, a control electrode
        coupled to the first node, and a second current
        electrode coupled to the second current
        electrode of the first transistor, and
    a third transistor having a first current electrode
        coupled to the second current electrodes of the first and second transistors, a control electrode for receiving a signal which is complementary to the enable signal, and a second current electrode coupled to a reference terminal.

5. In an output buffer for receiving complementary data signals, a method comprising the steps of:

providing output signals on first and second nodes in response to complementary data signals when an enable signal is present; and

latching the output signals on the first and second nodes when the enable signal is not present.

6. An output buffer, comprising:

a first amplifier having a first input for receiving a true data signal, a second input for receiving a complementary data signal, and first and second outputs;

a second amplifier having a first input directly connected to the first output of the first amplifier, a second input directly connected to the second output of the first amplifier, and first and second outputs; and

a latch coupled to the first and second outputs of the first amplifier for latching signals present thereat when an enable signal is present.

7. The output buffer of claim 6, wherein the first amplifier is characterized as being operational only when the enable signal is not present.

8. An output buffer, comprising:

a first transistor having a first current electrode coupled to a first node, a control electrode for receiving a true data signal, and a second current electrode;

a second transistor having a first current electrode coupled to a second node, a control electrode for receiving a complementary data signal, and a second current electrode coupled to the second current electrode of the first transistor;

a first load device coupled between the first node and a first power supply terminal,

a second load device coupled between the second node and the first power supply terminal;

a third transistor having a first current electrode coupled to the first node, a control electrode coupled to the second node, and a second current electrode;

a fourth transistor having a first current electrode coupled to the second node, a control electrode coupled to the first node, and a second current electrode coupled to the second current electrode of the third transistor;

a fifth transistor having a first current electrode coupled to the second current electrodes of the third and fourth transistors, a control electrode for receiving a true enable signal, and a second current electrode coupled to a second power supply terminal; and

a sixth transistor having a first current electrode coupled to the second current electrodes of first and second transistors, a control electrode for receiving a complementary enable signal, and a second current electrode coupled to the second power supply terminal.

9.   The output buffer of claim 8 wherein the enable signal is an equalization pulse.

10. The output buffer of claim 9 further comprising an amplifier having a first input directly connected to the first node, a second input directly connected to the second node, and an output for providing a data out signal.

0136486

FIG. 1

FIG. 2